Europäisches Patentamt

European Patent Office

Office européen des brevets

(11) Numéro de publication : **0 506 547 B1**

(12) **FASCICULE DE BREVET EUROPEEN**

(45) Date de publication du fascicule du brevet :
10.05.95 Bulletin 95/19

(51) Int. Cl.⁶ : **H03G 3/00,** H03G 1/00,
H03G 3/20

(21) Numéro de dépôt : **92400796.6**

(22) Date de dépôt : **24.03.92**

(54) **Dispositif de réglage automatique de niveau d'un signal.**

(30) Priorité : **26.03.91 FR 9103645**

(43) Date de publication de la demande :
**30.09.92 Bulletin 92/40**

(45) Mention de la délivrance du brevet :
**10.05.95 Bulletin 95/19**

(84) Etats contractants désignés :
**AT BE CH DE ES FR GB IT LI NL SE**

(56) Documents cités :
**GB-A- 2 097 619
US-A- 4 531 229
US-A- 4 771 472
PATENT ABSTRACTS OF JAPAN vol. 8, no.
127 (E-250)(1564) 14 Juin 1984**

(73) Titulaire : **ALCATEL CIT
12 Rue de la Baume
F-75008 Paris (FR)**

(72) Inventeur : **Bouriot, Dominique
14, rue du Royaume
F-91440 Bures sur Yvette (FR)**

(74) Mandataire : **Weinmiller, Jürgen, Dipl.-Ing. et
al
SPOTT, WEINMILLER & PARTNER
Postfach 24
D-82336 Feldafing (DE)**

## Description

La présente invention concerne un dispositif de réglage automatique de niveau d'un signal, dit incident, reçu par ce dispositif, fournissant en réponse un signal dit de sortie de niveau sensiblement égal, quelles que soient les variations du signal incident, à un niveau constant éventuellement sélectionnable parmi "n" niveaux possibles.

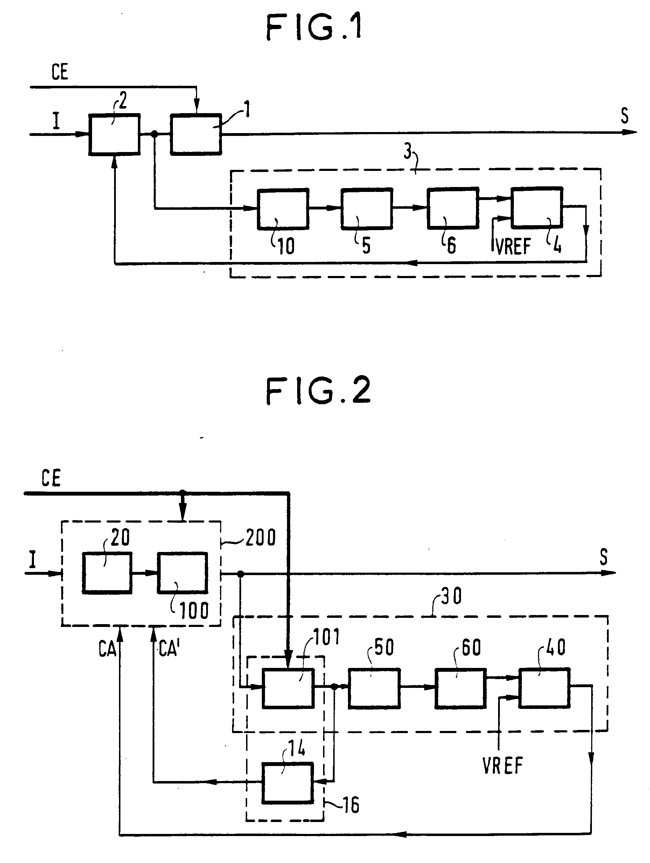

Il est connu de réaliser un tel dispositif de réglage automatique suivant le schéma de la figure 1, où la référence 1 désigne un amplificateur, dit de sortie, dont le niveau du signal de sortie, S, est à régler de façon automatique, et où la référence 2 désigne un atténuateur qui reçoit le signal incident, I, fournit en réponse le signal d'entrée de l'amplificateur de sortie 1, et est en outre commandé par une commande dite d'asservissement CA élaborée par une boucle d'asservissement 3, de façon à maintenir le niveau du signal d'entrée de l'amplificateur 1 constant quel que soit le niveau du signal incident I. Cette boucle d'asservissement comporte elle-même un comparateur, amplificateur 4 qui compare, par rapport à un niveau de référence VREF, le niveau du signal de sortie de cet atténuateur, après redressement dans un redresseur 5 et filtrage dans un filtre passe-bas 6.

Suivant la valeur des niveaux à obtenir pour les applications considérées, il peut être nécessaire d'amplifier les signaux avant redressement et filtrage dans la boucle d'asservissement. Sur la figure 1, une telle amplification est réalisée par un amplificateur 10, dit amplificateur de boucle, à gain constant.

Sur la figure 1, le niveau de sortie de l'amplificateur 1 est en outre sélectionnable parmi "n" niveaux possibles, ce qui est en l'occurrence obtenu par une commando correspondante CE du gain de l'amplificateur 1, dite commando externe.

Le schéma ainsi rappelé présente certains inconvénients. En effet, suivant la constante de temps du filtre passe-bas 6, la boucle d'asservissement 3 est plus ou moins efficace contre d'éventuelles surtensions apparaissant sur le signal incident.

En outre, lorsque le redresseur est un redresseur simple alternance, ce qui a pour avantage de procurer une simplification au plan de la réalisation de ce redresseur, cette boucle d'asservissement n'est pas non plus efficace contre d'éventuelles surtensions apparaissant dans les alternances du signal incident non prises en compte par ce redresseur, notamment à la mise en service du dispositif ou aux changements de fréquences se produisant dans ledit signal incident.

La présente invention a pour objet un dispositif de réglage automatique de niveau d'un signal dit incident reçu par ce dispositif, fournissant en réponse un signal dit de sortie de niveau sensiblement égal, quelles que soient les variations du signal incident, à un niveau constant éventuellement sélectionnable parmi "n" niveaux possibles (n, nombre entier supérieur à 1) en fonction d'une commande externe de gain appliquée audit dispositif, comportant un circuit de réglage de niveau muni d'une boucle d'asservissement de gain qui élabore une commande fonction du niveau du signal de sortie et éventuellement commandé en outre par ladite commande externe de gain pour fournir, en réponse audit signal incident, ledit signal de sortie, essentiellement caractérisé en ce que ladite boucle d'asservissement de gain qui élabore une commande fonction du niveau du signal de sortie étant dite première boucle, ledit circuit de réglage de niveau est en outre muni d'une seconde boucle d'asservissement de gain qui élabore une commande fonction de l'amplitude instantanée du signal de sortie. D'autres dispositifs de réglage automatique de niveau d'un signal munis de deux boucles d'asservissement de gain sont connus de US-A-4531229 et US-A-4771472. Toutefois, et contrairement à la présente invention, l'amplitude du signal de sortie de ces dispositifs n'est normalement pas constante, et les commandes automatiques de gain présentent toutes une constante de temps non nulle, ce qui ne permet pas d'éliminer toutes les surtensions du signal incident dans les circuits antérieurs.

D'autres objets et caractéristiques de la présente invention apparaîtront à la lecture de la description suivante d'un exemple de réalisation, faite en relation avec les dessins ci-annexés dans lesquels, outre la figure 1 déjà décrite, et relative à l'art antérieur :

- la figure 2 est un schéma synoptique d'un dispositif de réglage automatique de niveau d'un signal incident, suivant l'invention,
- la figure 3 est un schéma synoptique d'un dispositif de réglage automatique suivant l'invention, illustrant un mode possible de commande de gain du circuit dit de réglage et d'un amplificateur dit de boucle inclus dans ladite première boucle,
- la figure 4 est un schéma de réalisation possible d'un dispositif de réglage automatique de niveau d'un signal incident correspondant au schéma synoptique de la figure 3,
- la figure 5 est un schéma de réalisation possible du mode de commande simultanée du gain du circuit dit de réglage de niveau et de l'amplificateur dit de boucle, par ladite commande externe de gain, tel qu'illustré sur la figure 3,
- la figure 6 est un premier schéma de réalisation possible de moyens d'adaptation d'amplitude pouvant être inclus dans ladite seconde boucle d'asservissement,
- la figure 7 est un deuxième schéma de réalisation possible de tels moyens d'adaptation d'amplitude.

Le schéma synoptique d'un dispositif de réglage automatique suivant l'invention illustré sur la figure 2 comporte à titre d'exemple un atténuateur, repéré ici 20 et recevant le signal incident I, et un amplificateur dit de sortie, repéré 100, et fournissant, en réponse au signal issu de cet atténuateur, ledit signal de sortie. Ces deux éléments forment un ensemble 200 appelé circuit de réglage de niveau, qui suivant l'application envisagée, pourrait éventuellement se réduire à un seul de ces éléments.

Ce circuit de réglage de niveau est commandé d'une part par une commande d'asservissement de gain, CA, en vue de fournir un signal de sortie S de niveau sensiblement constant, quelles que soient les variations de niveau du signal incident, et d'autre part par une commande externe de gain, CE, en vue de sélectionner ce niveau parmi "n" niveaux possibles.

La boucle d'asservissement, repérée ici 30, fournissant ladite commande d'asservissement, comporte dans l'ordre, un redresseur 50, un filtre passe-bas 60, et un comparateur-amplificateur 40 qui compare le niveau de signal obtenu en sortie du filtre passe-bas 60 à un niveau de référence fixe VREF.

La boucle d'asservissement 30 est en l'occurence alimentée par le signal de sortie S qui est appliqué dans cette boucle à un amplificateur 101, dit de boucle, dont le gain est commandé, avec celui du circuit de réglage de niveau 200, par ladite commande externe CE, de telle sorte que le produit des gains du circuit de réglage de niveau et de l'amplificateur de boucle soit sensiblement indépendant du niveau sélectionné pour le signal de sortie.

Suivant l'invention, le schéma synoptique de la figure 2 inclut une seconde boucle d'asservissement de gain, 16, du circuit de réglage de niveau en fonction de l'amplitude instantanée du signal de sortie, permettant d'éviter les inconvénients dus au temps de réaction de la boucle d'asservissement 30 et/ou à la non prise en compte de l'une des alternances du signal incident dans cette première boucle d'asservissement lorsque le redresseur utilisé dans cette boucle est un redresseur simple-alternance. Cette seconde boucle d'asservissement 16 élabore une commande d'asservissement de gain, CA', du circuit de réglage de niveau 200, en l'occurence à partir du signal issu de l'amplificateur 101 mais non redressé, de façon à tenir compte, pour ce second asservissement, d'éventuelles surtensions présentes dans le signal incident, notamment celles des alternances non prise en compte par le redresseur 50 lorsque celui-ci est un redresseur simple alternance.

Cette seconde boucle d'asservissement peut comporter, en fonction de l'amplitude nécessaire à la commande de gain du circuit de réglage, des moyens 14 d'adaptation d'amplitude.

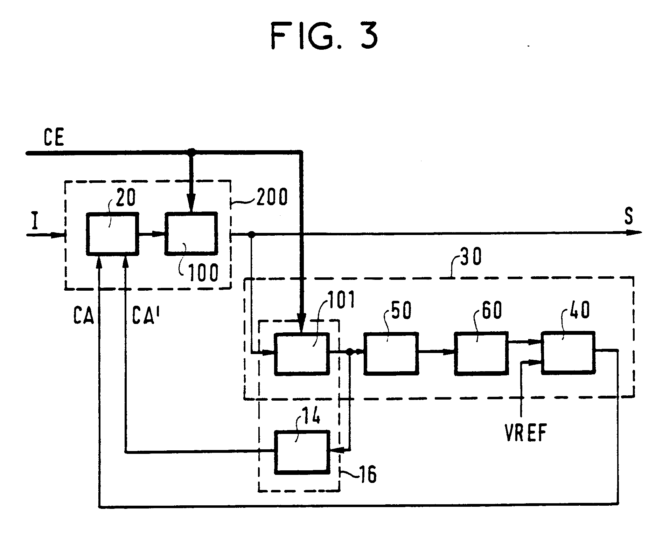

La figure 3 illustre un mode avantageux de définition du gain du circuit de réglage de niveau, par commande du gain de l'amplificateur de sortie 100 au moyen de ladite commande externe CE, et par asservissement de l'atténuation procurée par l'atténuateur 20 au moyen de ladite boucle d'asservissement 30.

Dans ce mode, l'atténuateur 20 est muni d'une deuxième entrée d'asservissement, recevant en l'occurrence la commande d'asservissement CA'.

Il n'en demeure pas moins que d'autres modes de réalisation sont possibles. On peut, par exemple, inverser les commandes repérées CA-CA' avec la commande repérée CE, ce qui revient à utiliser ladite commande externe CE pour jouer sur l'atténuation procurée par l'atténuateur 20 et commander le gain de l'amplificateur de sortie 100 au moyen desdites commandes d'asservissement CA-CA'. On peut aussi en fonction de l'application envisagée, appliquer les deux types de commande de façon conjointe sur un seul des deux éléments constituant le circuit de réglage de niveau ou éventuellement sur le seul élément pouvant constituer le circuit de réglage de niveau.

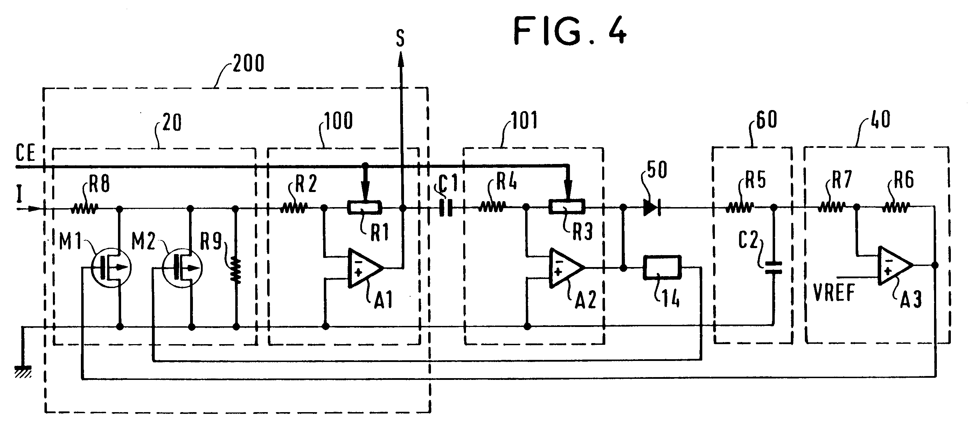

On décrit maintenant, en relation avec la figure 4, un schéma de réalisation possible d'un dispositif suivant la figure 3.

On retrouve sur cette figure :
- l'amplificateur de sortie 100, qui est en l'occurrence un amplificateur opérationnel A1 muni d'une résistance de contre-réaction commandable R1, et ayant en l'occurrence son entrée additive, notée "+", mise à la tension de référence, schématisée ici par la masse, son entrée soustractive notée "-", recevant le signal de sortie de l'atténuateur 20 via une résistance d'entrée R2, et sa sortie fournissant le signal de sortie S de ce dispositif,
- l'amplificateur de boucle 101, qui est également en l'occurrence un amplificateur opérationnel, A2, muni d'une résistance de contre-réaction commandable R3, et ayant en l'occurrence son entrée additive, notée "+", également à la tension de référence, schématisé ici par la masse, son entrée soustractive, notée "-", connectée à la sortie de l'amplificateur, de sortie 100 à travers un filtre passe-haut (condensateur C1 en série avec une résistance d'entrée R4),
- le redresseur 50, en l'occurence un redresseur simple alternance formé par exemple d'une diode reliée à la sortie de l'amplificateur de boucle 101,
- le filtre passe-bas 60, connecté en sortie du redresseur 50 et formé en l'occurrence d'une cellule R-C comportant une résistance série R5 et un condensateur parallèle C2, cette cellule présentant une faible constante de temps vis à vis de celle constituée du même condensateur C2 et de la résistance R7 d'entrée du comparateur 40,
- le comparateur 40, qui est en l'occurrence un amplificateur opérationnel A3 muni d'une résistance de contre-réaction R6, et ayant dans le cas présent son entrée additive, notée "+", mise à un niveau de référence $V_{REF}$, et son entrée soustractive, notée "-", connectée à la sortie du filtre passe-bas 6 au travers de ladite résistance R7,

- l'atténuateur 20, qui est en l'occurrence un diviseur de tension formé d'une résistance série fixe R8 et d'une impédance parallèle variable constituée ici de trois éléments en parallèle M1, M2 et R9 où R9 désigne une résistance fixe et M1 et M2 deux éléments d'impédance commandable, la tension d'entrée de ce diviseur de tension étant formée du signal incident I, et la tension de sortie de ce diviseur de tension, constituant la tension appliquée en l'occurrence à l'entrée soustractive de l'amplificateur 100, étant prise aux bornes de l'impédance commandable que forment les trois éléments en parallèle M1, M2, R9,

- le moyen d'adaptation d'amplitude 14 de la seconde boucle d'asservissement, dont l'entrée est reliée à la sortie de l'amplificateur de boucle 101 et dont la sortie est appliquée à l'entrée de commande d'asservissement de l'élément M2 de l'atténuateur 20, la sortie du comparateur 40 étant quant à elle appliquée à l'entrée de commande d'asservissement de l'élément M1 de l'atténuateur 20.

Les éléments M1 et M2 sont en l'occurrence des transistors à effet de champ dont la grille reçoit respectivement le signal issu du comparateur 40 et le signal issu du moyen d'adaptation d'amplitude 14.

Ainsi, lorsque l'écart entre le niveau du signal représentatif du signal incident, appliqué sur le comparateur 40, et le niveau de référence VREF, augmente, la conduction du transistor M1 est modifiée, ce qui entraîne une modification de l'affaiblissement de l'atténuateur 20 qui va tendre à réduire cet écart.

De même lorsque l'amplitude instantanée du signal issu du moyen d'adaptation de niveau 14 dépasse un certain seuil, la conduction du transistor M2 est telle que l'affaiblissement de l'atténuateur 20 se trouve modifié de façon à réduire cette amplitude instantanée.

En outre, il apparaît dans le montage ainsi décrit en relation avec la figure 4 que les signaux de sortie de l'amplificateur-comparateur 40 sont inversés par rapport aux signaux de sortie de l'amplificateur de boucle 101; ceci permet à la seconde boucle d'asservissement d'être efficace sur celles des alternances du signal incident qui ne sont pas prises en compte par le redresseur simple-alternance 50; ceci malgré l'utilisation de deux transistors à effet de champ, M1-M2, de même type.

On notera par ailleurs que le filtre passe-haut, constitué en l'occurrence par un condensateur C1, inséré entre la sortie de l'amplificateur 100 et l'entrée de l'amplificateur 101 a pour rôle d'éliminer la tension d'"offset" de l'amplificateur 100.

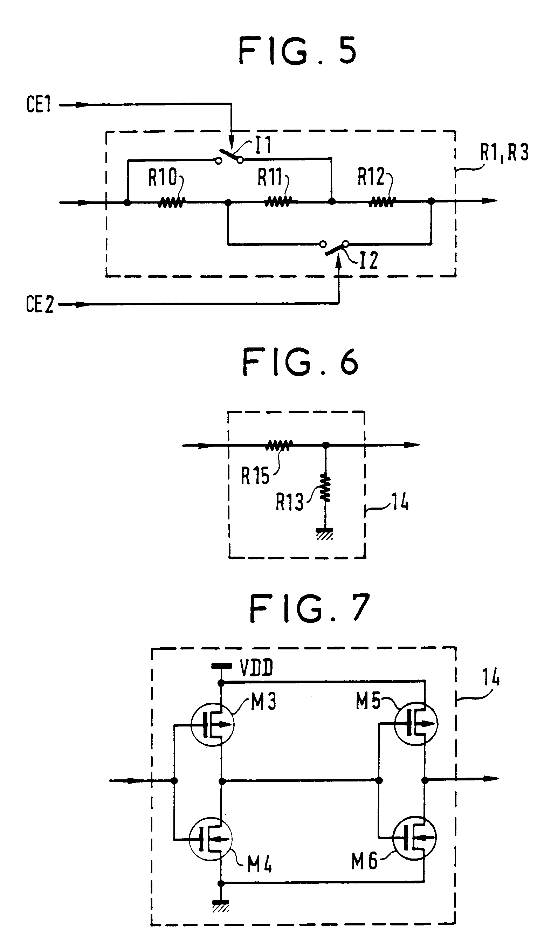

Le gain des amplificateurs 100 et 101 s'exprimant sur le schéma de la figure 4 en fonction respectivement des résistances de contre-réaction R1 et R3, la figure 5 représente un schéma de réalisation possible de telles résistances de contre-réaction R1 et R3 commandables simultanément de façon à garder en permanence le produit des gains des amplificateurs 100 et 101 sensiblement indépendant du niveau sélectionné pour le signal de sortie.

Ce schéma consiste en une association d'un certain nombre de résistances fixes, en l'occurrence trois résistances, R10, R11, R12, suivant une configuration modifiable par action sur un certain nombre d'interrupteurs commandables, en l'occurrence deux interrupteurs I1, I2 commandés respectivement par des signaux binaires CE1, CE2 de façon que lorsque ces deux interrupteurs sont ouverts, ces trois résistances se trouvent associées en série, d'où pour l'ensemble une valeur de résistance Rmax, que lorsque l'un de ces deux interrupteurs est ouvert et l'autre fermé, deux de ces trois résistances en série soient court-circuitées, l'ensemble étant équivalent à une seule résistance, d'où pour l'ensemble une valeur de résistance moyenne Rmoy, et que lorsque ces deux interrupteurs sont fermés, ces trois résistances se trouvent associées en parallèle, d'où pour l'ensemble une valeur de résistance minimale Rmin.

Les signaux de commande CE1 et CE2 des interrupteurs I1 et I2 étant inversés pour les deux amplificateurs 100 et 101, et la valeur absolue du gain $G_1$ de l'amplificateur 100 s'exprimant en l'occurrence sous la forme $|G_1| = \dfrac{R1}{R2}$ et celle du gain G2 de l'amplificateur 101 sous la forme $|G_2| = \dfrac{R3}{R4}$, les valeurs des résistances R1 et R3 sont en outre déterminées de façon à avoir sensiblement $R1_{min} \cdot R3_{max} = R1_{moy} \cdot R3_{moy} = R1_{max} \cdot R3_{min}$.

Les moyens d'adaptation d'amplitude 14 représentés sur la figure 6 comportent un diviseur de tension formé au moyen de deux résistances R15, R13.

Les moyens d'adaptation d'amplitude 14 représentés sur la figure 7 comportent un dispositif à seuil formé par association de deux montages formés chacun par association en série de deux transistors à effet de champ de types opposés, respectivement M3, M4 et M5, M6 et connus pour réaliser chacun une fonction d'inversion d'un signal appliqué à son entrée. L'entrée du premier montage M3, M4 constitue l'entrée de ces moyens d'adaptation d'amplitude, la sortie du premier montage est appliquée à l'entrée du deuxième montage M5, M6 et la sortie du deuxième montage constitue la sortie de ces moyens d'adaptation d'amplitude. Les tensions d'alimentation de transistors de même type sont en outre identiques, l'une de ces tensions d'alimentation étant repérée VDD et l'autre étant en l'occurrence la tension de référence schématisée ici par la masse, et des transistors de type opposés présentent des caractéristiques symétriques.

Suivant le signe et la valeur absolue de l'amplitude du signal d'entrée de ces moyens d'adaptation d'amplitude, l'un ou l'autre des transistors M3 et M4 conduit, ce qui entraîne la conduction de l'un ou l'autre respectivement des transistors M6 et M5 auquel cas le signal obtenu en sortie de ces moyens d'adaptation d'amplitude est fonction du signal d'entrée et des caractéristiques de conduction des transistors utilisés.

## Revendications

1. Dispositif de réglage automatique de niveau d'un signal dit incident (I) reçu par ce dispositif, fournissant en réponse un signal dit de sortie (S) de niveau sensiblement égal, quelles que soient les variations du signal incident, à un niveau constant, éventuellement sélectionnable parmi "n" niveaux possibles (n, nombre envier supérieur à 1) en fonction d'une commande externe de gain (CE) appliquée audit dispositif, comportant un circuit (200) de réglage de niveau muni d'une boucle (30) d'asservissement de gain qui élabore une commande fonction du niveau du signal de sortie et éventuellement commandé en outre par ladite commande externe de gain pour fournir, en réponse audit signal incident, ledit signal de sortie, caractérisé en ce que ladite boucle d'asservissement de gain qui élabore une commande fonction du niveau du signal de sortie étant dite première boucle, ledit circuit de réglage de niveau est en outre muni d'une seconde boucle (16) d'asservissement de gain qui élabore une commande fonction de l'amplitude instantanée du signal de sortie.

2. Dispositif selon la revendication 1, caractérisé en ce que ladite commande élaborée en fonction de l'amplitude instantanée du signal de sortie consiste à prendre en compte un franchissement, par ladite amplitude instantanée, d'un seuil déterminé.

3. Dispositif selon l'une des revendications 1 et 2, caractérisé en ce que ledit circuit de réglage de niveau comporte un élément formé par un amplificateur à gain réglable (100).

4. Dispositif selon l'une des revendications 1 à 2, caractérisé en ce que ledit circuit de réglage de niveau comporte un élément formé par un atténuateur à atténuation réglable (20).

5. Dispositif selon l'une des revendications 1 et 2, caractérisé en ce que ledit circuit de réglage de niveau comporte deux éléments en série formés respectivement par un atténuateur (20) et par un amplificateur (100), l'un et/ou l'autre de ces éléments ayant son gain, ou son atténuation, réglable.

6. Dispositif selon l'une des revendications 3 à 5, caractérisé en ce que l'un des éléments du circuit de réglage de niveau comporte à son tour deux éléments commandés respectivement par la sortie de chacune desdites boucles.

7. Dispositif selon l'une des revendications 1 à 6, caractérisé en ce que la seconde boucle d'asservissement comporte des moyens (14) d'adaptation de l'amplitude de son signal d'entrée à l'amplitude nécessaire à la commande dudit circuit de réglage de niveau.

8. Dispositif selon l'une des revendications 1 à 6, caractérisé en ce que ladite première boucle d'asservissement comporte un redresseur simple-alternance (50).

9. Dispositif selon la revendication 6, caractérisé en ce que ledit élément du circuit de réglage de niveau comportant à son tour deux éléments commandés respectivement par la sortie de chacune desdites boucles étant un atténuateur à atténuation réglable, cet atténuateur comporte un diviseur de tension comportant deux composants d'impédance réglable (M1, M2) montés en parallèle, et commandés respectivement par les signaux issus de la première et la deuxième boucle d'asservissement.

10. Dispositif selon les revendications 2 et 9, caractérisé en ce que ledit composant d'impédance réglable commandé par le signal issu de la deuxième boucle d'asservissement comporte un transistor (M2) dont le seuil de conduction correspond audit seuil déterminé.

11. Dispositif selon la revendication 7, caractérisé en ce que lesdits moyens d'adaptation d'amplitude comportent un circuit diviseur de tension.

12. Dispositif selon la revendication 7, caractérisé en ce que lesdits moyens d'adaptation d'amplitude comportent un circuit à seuil.

## Patentansprüche

1. Vorrichtung zur automatischen Regelung des Pegels eines ankommenden Signals (I), die als Antwort ein Ausgangssignal (S) eines im wesentlichen konstanten Pegels liefert, unabhängig von den Veränderungen des ankommenden Signals, wobei der konstante Pegel ggf. aus n möglichen Pegeln (n ist eine ganze Zahl größer als 1) abhängig von einer äußeren Verstärkungssteuerung (CE) auswählbar ist, die an die Vorrichtung angelegt wird, wobei die Vorrichtung eine Schaltung (200) zur Pegelregelung mit einer Verstärkungsregelschleife (30) enthält, welche eine vom Pegel des Ausgangssignals abhängige Stellgröße erarbeitet und ggf. außerdem von der äußeren Verstärkungssteuerung gesteuert wird, um als Antwort auf das ankommende Signal das Ausgangssignal zu liefern, dadurch gekennzeichnet, daß die Verstärkungsregelschleife, die eine Stellgröße abhängig vom Pegel des Ausgangssignals erarbeitet, als erste Schleife bezeichnet wird und daß die Pegelregelschaltung außerdem eine zweite Verstärkungsregelschleife (16) enthält, die eine Stellgröße abhängig von der augenblicklichen Amplitude des Ausgangssignals erarbeitet.

2. Vorrichtung nach Anspruch 1, dadurch gekennzeichnet, daß die abhängig von der augenblicklichen Amplitude des Ausgangssignals erarbeitete Stellgröße darin besteht, eine Überschreitung einer gegebenen Schwelle durch die augenblickliche Amplitude zu berücksichtigen.

3. Vorrichtung nach einem der Ansprüche 1 und 2, dadurch gekennzeichnet, daß die Pegelregelschaltung ein Element enthält, das von einem Verstärker mit regelbarem Verstärkungsgrad (100) gebildet wird.

4. Vorrichtung nach einem der Ansprüche 1 bis 2, dadurch gekennzeichnet, daß die Pegelregelschaltung ein Element enthält, das von einem Dämpfungsglied mit regelbarer Dämpfung (20) gebildet wird.

5. Vorrichtung nach einem der Ansprüche 1 und 2, dadurch gekennzeichnet, daß die Pegelregelschaltung zwei Elemente in Reihe enthält, die von einem Dämpfungsglied (20) sowie von einem Verstärker (100) gebildet werden, wobei der Verstärkungs- bzw. Dämpfungsgrad des einen und/oder anderen Elements regelbar ist.

6. Vorrichtung nach einem der Ansprüche 3 bis 5, dadurch gekennzeichnet, daß eines der Elemente des Pegelregelkreises seinerseits zwei Elemente enthält, die von der Ausgangsspannung je einer der Regelschleifen gesteuert werden.

7. Vorrichtung nach einem der Ansprüche 1 bis 6, dadurch gekennzeichnet, daß die zweite Regelschleife Mittel (14) zur Anpassung der Amplitude ihres Eingangssignals an die Amplitude besitzt, die für die Steuerung der Pegelregelschaltung notwendig ist.

8. Vorrichtung nach einem der Ansprüche 1 bis 6, dadurch gekennzeichnet, daß die erste Regelschleife einen Einweg-Gleichrichter (50) enthält.

9. Vorrichtung nach Anspruch 6, dadurch gekennzeichnet, daß das Element der Pegelregelschaltung, die zwei Elemente enthält, die vom Ausgang einer der Schleifen gesteuert werden, ein Dämpfungsglied mit regelbarer Dämpfung ist, das einen Spannungsteiler mit zwei regelbaren Impedanzbauteilen (M1, M2) in Parallelschaltung enthält, die von den Ausgangssignalen der ersten bzw. zweiten Regelschleife gesteuert werden.

10. Vorrichtung nach einem der Ansprüche 2 und 9, dadurch gekennzeichnet, daß das Bauelement mit regelbarer Impedanz, das vom Ausgangssignal der zweiten Schleife gesteuert wird, einen Transistor (M2) enthält, dessen Leitschwelle der vorbestimmten Schwelle entspricht.

11. Vorrichtung nach Anspruch 7, dadurch gekennzeichnet, daß die Mittel zur Amplitudenanpassung eine Spannungsteilerschaltung aufweisen.

12. Vorrichtung nach Anspruch 7, dadurch gekennzeichnet, daß die Mittel zur Amplitudenanpassung eine Schwellwertschaltung enthalten.

**Claims**

1. Device for automatically adjusting the level of an incoming signal (I) received by said device which supplies in response thereto an output signal (S) of substantially constant level regardless of variations in the incoming signal, optionally selectable from "n" possible levels (n is an integer greater than 1) according to an external gain control signal (CE) applied to said device, including a level adjuster circuit (200) having a gain control loop (3) which produces a control signal dependent on the level of the output signal and optionally further conditioned by said external gain control signal to provide said output signal in response to said incoming signal, characterised in that said gain control loop which produces a control signal dependent on the level of the output signal constitutes a first loop and said level adjuster circuit is further provided with a second gain control loop (16) which produces a control signal dependent on the instantaneous amplitude of the output signal.

2. Device according to claim 1 characterised in that said control signal dependent on the instantaneous amplitude of the output signal is conditioned by said instantaneous amplitude crossing a specific threshold.

3. Device according to claim 1 or claim 2 characterised in that said level adjuster circuit includes a component in the form of a variable gain amplifier (100).

4. Device according to claim 1 or claim 2 characterised in that said level adjuster circuit includes a component in the form of a variable attenuator (20).

5. Device according to claim 1 or claim 2 characterised in that said level adjuster circuit includes two components in series respectively in the form of an attenuator (20) and an amplifier (100), one or both of said components having a variable gain or attenuation.

6. Device according to any one of claims 3 to 5 characterised in that one component of the level adjuster circuit includes two components controlled by the outputs of respective loops.

7. Device according to any one of claims 1 to 6 characterised in that the second control loop includes means (14) for adapting the amplitude of its input signal to the amplitude needed to control said level adjuster circuit.

8. Device according to any one of claims 1 to 6 characterised in that said first control loop includes a half-wave rectifier (50).

9. Device according to claim 6 characterised in that said component of the level adjuster circuit including two components controlled by the outputs of respective loops a variable attenuator and said attenuator includes a voltage divider including two variable impedance components (M1, M2) in parallel respectively controlled by the output signals of the first and second control loops.

10. Device according to claims 2 and 9 characterised in that said variable impedance component controlled by the signal from the second control loop includes a transistor (M2) whose conduction threshold corresponds to said specific threshold.

11. Device according to claim 7 characterised in that said amplitude adapter means include a voltage divider circuit.

12. Device according to claim 7 characterised in that said amplitude adapter means include a threshold circuit.

# FIG.1

# FIG.2

# FIG. 3

# FIG. 4

EP 0 506 547 B1

# FIG. 5

# FIG. 6

# FIG. 7